# EUROPEAN PATENT SPECIFICATION

(11) **EP 3 547 537 B1**
(45) Date of publication and mention of the grant of the patent: **25.02.2026**
(21) Application number: 19165732.9
(22) Date of filing: 28.03.2019
(51) Int. Cl.: H03G 11/00, H01P 1/14

(54) **MICRO PLASMA LIMITER FOR RF AND MICROWAVE CIRCUIT PROTECTION**
MIKROPLASMABEGRENZER FÜR HF- UND MIKROWELLENSCHALTUNGSSCHUTZ
LIMITEUR DE MICRO PLASMA POUR PROTECTION DE CIRCUIT RF ET HYPERFRÉQUENCE

(30) Priority: 30.03.2018 US 201815942004
(43) Date of publication of application: 02.10.2019
(73) Proprietor: The Boeing Company, Arlington, VA 22202 (US)
(72) Inventor: LAM, Tai Anh, Chicago, IL 60606-2016 (US)
(74) Representative: Boult Wade Tennant LLP

(56) References cited:
- US-A- 3 113 278
- US-A- 4 575 692
- US-A1- 2015 244 048
- CROSS LEE W ET AL: "Theory and Demonstration of Narrowband Bent Hairpin Filters Integrated With AC-Coupled Plasma Limiter Elements", IEEE TRANSACTIONS ON ELECTROMAGNETIC COMPATIBILITY, IEEE SERVICE CENTER, NEW YORK, NY, US, vol. 55, no. 6, 1 December 2013 (2013-12-01), pages 1100 - 1106, XP011533368, ISSN: 0018-9375, [retrieved on 20131211], DOI: 10.1109/TEMC.2013.2247403
- HORTON J B ET AL: "A One-GHz Ferroelectric Limiter", IEEE TRANSACTIONS ON MICROWAVE THEORY AND TECHNIQUES, PLENUM, USA, vol. 15, no. 9, 1 September 1967 (1967-09-01), pages 517 - 523, XP011385202, ISSN: 0018-9480, DOI: 10.1109/TMTT.1967.1126522
- JEFFREY HOPWOOD ET AL: "Microplasmas ignited and sustained by microwaves", PLASMA SOURCES SCIENCE AND TECHNOLOGY, INSTITUTE OF PHYSICS PUBLISHING, BRISTOL, GB, vol. 23, no. 6, 4 December 2014 (2014-12-04), pages 64002, XP020274320, ISSN: 0963-0252, [retrieved on 20141204], DOI: 10.1088/0963-0252/23/6/064002

## Description

### BACKGROUND

Many electronic circuits are susceptible to damage caused by high power signals. For example, Radio Frequency (RF) equipment, e.g., low noise amplifiers, down converter mixer circuits, etc., designed to detect low power signals, signals in noisy environments, etc., are generally susceptible to being damaged by high power signals. Such high power signals may present in any number of forms (e.g., high power microwave signals, electromagnetic pulses, etc.) and/or be caused by any number of circumstances (e.g., signals transmitted by radar transmitters, lightning strikes, power supply surges, static electricity, interference, co-site interference for simultaneous transmit/receive systems, etc.). Thus, it is necessary to either prevent such high power signals from happening, or to provide some means to protect delicate electronics from such high power signals.

Conventional electrical systems may use a surge protection device to prevent high power signals from reaching the delicate electronics. For example, current limiters may use special diodes, e.g., P-doped, Intrinsic, N-doped (PIN) diodes, to block high power signals. Such protection circuits, however, are expensive, have a limited power handling capacity, and/or have a high insertion loss. As such, there remains a need for improved protection circuits that protect power-sensitive electronics from high power signals.

US-A1-2015/244048, in accordance with its abstract, states a plasma power limiter fabricated using wafer-level fabrication techniques with other circuit elements. The power limiter includes a signal substrate having a first side and a second side, an input signal line formed on the first side, a signal transmission line formed on the second side and an output signal line formed on the first side. The power limiter also includes a ground substrate having a first side and a second side, and being bonded to the signal substrate to form a sealed cavity including an ionizable gas therebetween. The ground substrate includes a ground metal layer formed on the second side. A signal propagating on the input signal line at a power level greater than a threshold power level generates a voltage potential across the cavity that ionizes the gas and generates a plasma discharge, and limits power of the output signal coupled to the output signal line.

US-A-4,575,692, in accordance with its abstract, states a microwave gas discharge apparatus for use as a limiter or TR device or the like and employing a primary discharge arrangement which has a single resonator used for priming the discharge device and determining the priming energy frequency.

The paper *"*Theory and Demonstration of Narrowband Bent Hairpin Filters Integrated With AC-Coupled Plasma Limiter Elements"; Cross et al; IEEE Transactions on Electromagnetic Compatibility; Vol. 55, No. 6, Pages 1100-1106, December 2013, in accordance with its abstract, states a narrowband filter with integral high-power microwave limiter behavior. The filter-limiter consists of a third- order microstrip bent hairpin filter with encapsulated gas plasma limiters, designed for operation at 870 MHz. An equivalent circuit model is presented for the ac-coupled plasma-shell components used in the study, and parameter values were extracted from measured results and electromagnetic simulation. The theory of operation of the proposed filter-limiter was experimentally validated and key predictions were demonstrated including two modes of operation in the on-state: a constant output power mode and constant attenuation mode at relatively higher power. The filter-limiter operates passively from incident microwave energy, and can also use an external priming voltage source to reduce the limiter turn-on power threshold and reduce output power variation during limiting.

US-A-3,113,278 relates to microwave power limiters, and particularly limiters utilizing ferrites. US-A-3,113,278 states that a microwave resonator is employed, and a body of ferrite material is positioned in a relatively high R-F magnetic field region thereof. A D.-C. magnetic field is applied to the ferrite having a strength corresponding to a resonance peak in the ferrite near the resonator frequency, but displaced therefrom to provide a reactance component which shifts the resonant frequency of the resonator. The reactance component contributed by the ferrite will be different above and below the critical power level mentioned above, and therefore the resultant resonant frequency of the resonator will be different. Accordingly the attenuation of a signal will be different above and below the critical power level, and limiting will occur.

The paper *"*A One-GHz Ferroelectric Limiter"; Horton et al; IEEE Transactions on Microwave Theory and Techniques; Vol. 15, No. 9, Pages 517-523, 1 September 1967, in accordance with its abstract, states the design and analysis of a 1-GHz limiter which uses voltage variation of the dielectric constant of a ferroelectric material to achieve limiting is described. An RF electric field derived from the input power is used to change the relative dielectric constant *εᵣ* of the material; the resulting nonlinear change of capacitance of a small element of the material is used to change the condition of a tuned circuit. The tuned circuit terminates a quarter-wavelength stub which shunts the main transmission line, thereby providing a power-dependent mismatch at the junction of the two transmission lines. The degree of this mismatch is controlled by the condition of the tuned circuit and, therefore, the magnitude of the input power.

The paper *"*Microplasmas ignited and sustained by microwaves"; Hopwood et al; Plasma Sources Science and Technology; Institute of Physics Publishing, Vol. 24, No. 4, Page 064002; 4 December 2014, in accordance with its abstract, states the challenges and benefits of microwave-induced microdischarges are reviewed. Transmission lines, resonators and surface wave launchers may be used for coupling microwave power to very small plasmas. Fortunately, microplasmas are typically much smaller than the wavelength of microwaves, and the electromagnetic problem may be treated electrostatically within the plasma. It is possible to trap electrons within small discharge gaps if the amplitude of electron oscillation is smaller than the plasma size. Typically occurring above 0.3 GHz, this condition results in lower breakdown fields than are required by direct current or radio frequency systems. Trapping of electrons also decreases the electrode potential to only tens of volts and makes the plasma density invariant in time. The steady-state microplasma produces electron densities of up to 1015 cm-3 in argon but the electrons are not in equilibrium with the low gas temperatures (500-1000 K).

### SUMMARY

The present disclosure relates to methods, apparatuses, systems, computer program products, software, and/or mediums for improved protection from high power signals. To that end, examples presented herein use a limiter circuit comprising a phase changing material to prevent high power signals from reaching one or more electronic circuits. The phase changing material assumes a limiting state when an energy of an applied signal exceeds a threshold, which limits the energy of the signal passed on to any associated electronics.

In accordance with claim 1,there is described herein a protection circuit configured to protect one or more electronic circuits from high power signals, the protection circuit comprising: a first port and a second port respectively electrically connected to opposing ends of a transmission line, the second port operatively coupled to the one or more electronic circuits; and a limiter circuit selectively electrically coupled between the transmission line and ground; wherein the limiter circuit comprises a resonator and a phase changing material in communication with the resonator, the phase changing material configured in a limiting state when an energy of a signal received at the first port exceeds a threshold to limit an energy of the signal at the second port; wherein the resonator comprises a quarter wave resonator selectively electrically connected to the ground via the phase changing material; and wherein the limiting state comprises a conductive state that electrically connects the quarter wave resonator to the ground to redirect at least a portion of the energy of the signal received at the first port to the ground.

Optionally, the phase changing material is configured in a non-limiting state when the energy of the signal received at the first port is less than the threshold.

Optionally, the phase changing material configured in the limiting state absorbs at least some of the energy of the signal received at the first port to limit the energy of the signal at the second port.

Optionally, the protection circuit further comprises a gap chip comprising a sealed chamber, a first conductor, and a second conductor. Optionally, the phase changing material is disposed in the sealed chamber. Optionally, the first conductor is at least partially disposed within the sealed chamber and extends from the sealed chamber. Optionally, the second conductor is spaced from the first conductor, is at least partially disposed within the sealed chamber, and extends from the sealed chamber, where the first and second conductors electrically connect to the resonator.

Optionally, the phase changing material comprises air.

Optionally, the phase changing material comprises a noble gas, a thermochromic material, or an electrochromic material.

Optionally, the threshold comprises a fixed threshold.

Optionally, the limiter circuit further comprises a bias connector electrically connected to the resonator, where the threshold comprises a variable threshold controlled by a bias signal applied to the bias connector.

In accordance with claim 10, there is also described herein a method of protecting one or more electronic circuits from high power signals, the method comprising: receiving a signal at a first port of a transmission line, wherein the transmission line comprises the first port and a second port respectively electrically connected to opposing ends of the transmission line, wherein the second port is operatively coupled to the one or more electronic circuits, wherein a limiter circuit is selectively electrically coupled between the transmission line and ground, and wherein the limiter circuit comprises a resonator and a phase changing material in communication with the resonator; and limiting an energy of the signal at the second port when an energy of the signal received at the first port exceeds a threshold using the phase changing material configured in a limiting state; wherein the resonator comprises a quarter wave resonator selectively electrically connected to the ground via the phase changing material; and wherein the limiting state comprises a conductive state that electrically connects the quarter wave resonator to the ground to redirect at least a portion of the energy of the signal received at the first port to the ground.

Optionally, the method further comprises passing the energy of the signal at the first port to the second port when the energy of the signal received at the first port is less than the threshold using the phase changing material configured in a non-limiting state.

Optionally, the threshold comprises a fixed threshold.

Optionally, the threshold comprises a variable threshold, the method further comprising controlling the threshold by controlling a bias signal applied to the resonator.

In accordance with claim 15, there is also disclosed herein an aircraft comprising one or more electronic circuits, and a protection circuit. The one or more electronic circuits are configured to control an operation of the aircraft. The protection circuit comprises a first port and a second port electrically connected to opposing ends of a transmission line, the second port operatively coupled to the one or more electronic circuits; and a limiter circuit operatively coupled to the transmission line and comprising a phase changing material in communication with a resonator, the phase changing material configured in a limiting state when an energy of a signal received at the first port exceeds a threshold to limit an energy of the signal at the second port; wherein the resonator comprises a quarter wave resonator selectively connected to ground via the phase changing material; and the limiting state comprises a conductive state that electrically connects the quarter wave resonator to the ground.

Optionally, the limiter circuit further comprises a bias connector electrically connected to the resonator, where the threshold comprises a variable threshold controlled by a bias signal applied to the bias connector.

### BRIEF DESCRIPTION OF THE DRAWINGS

Figure 1 shows a block diagram of an electronic system.
Figure 2 shows a method of protecting electronic circuits from damage caused by high power signals.
Figure 3 shows a protection circuit.
Figure 4 shows a protection circuit.
Figure 5 shows a limiter circuit for the protection circuit.
Figure 6 shows a gap chip implementation of the phase changing material.
Figure 7 shows an exemplary slot resonator for the limiter circuit, not encompassed by the wording of the claims.
Figure 8 shows an exemplary quarter-wave resonator for the limiter circuit, in accordance with the claims.
Figure 9 shows a Printed Circuit Board (PCB) with an exemplary slot resonator, not encompassed by the wording of the claims.
Figure 10 shows a PCB.
Figure 11 shows a PCB comprising multiple limiter circuits, not encompassed by the wording of the claims.
Figure 12 shows a PCB comprising multiple limiter circuits, in accordance with the claims.
Figure 13 shows simulation results.

### DETAILED DESCRIPTION

The present disclosure is directed to methods, apparatuses, systems, computer program products, and/or software for limiting the energy of a signal applied to electronic circuits, particularly those circuits that could be damaged by high power signals. The examples presented herein are described in terms of electronic circuit protection, particularly the protection of RF circuits in general and on an aircraft in particular. It will be appreciated, however, that the examples presented herein are not limited to aircraft electronics, but rather apply to any electronics that are sensitive to, and may be damaged by, high power signals.

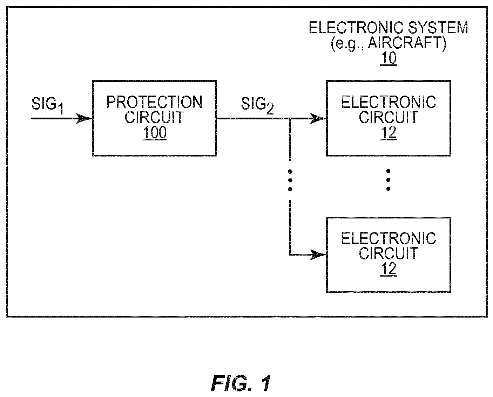

Figure 1 shows a block diagram of an electronic system 10, e.g., on an aircraft. Electronic system 10 comprises one or more electronic circuits 12 and a protection circuit 100. The electronic circuits 12 may comprise any electronic circuit that is sensitive to, or may be damaged by, high power signals. Exemplary electronic circuits 12 include, but are not limited to, radar systems, communication systems, sensing systems, low noise amplifiers, down converter mixers, etc. Protection circuit 100 protects the electronic circuits 12 from high power/high energy signals by at least partially blocking and/or redirecting the high power signals using a phase changing material that changes to a limiting state when *SIG₁* is a high power signal, e.g., when the energy of *SIG₁* exceeds a threshold.

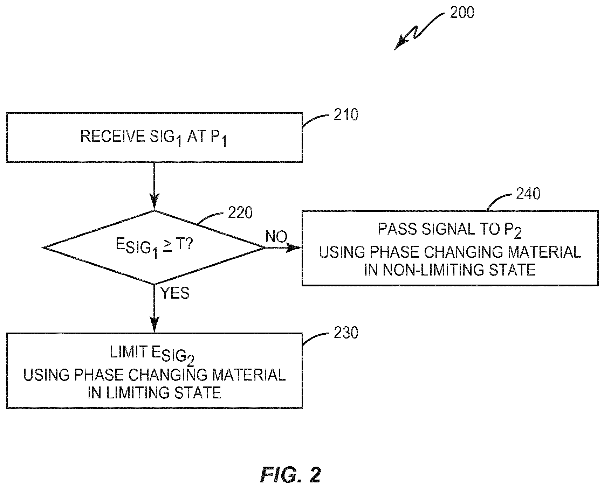

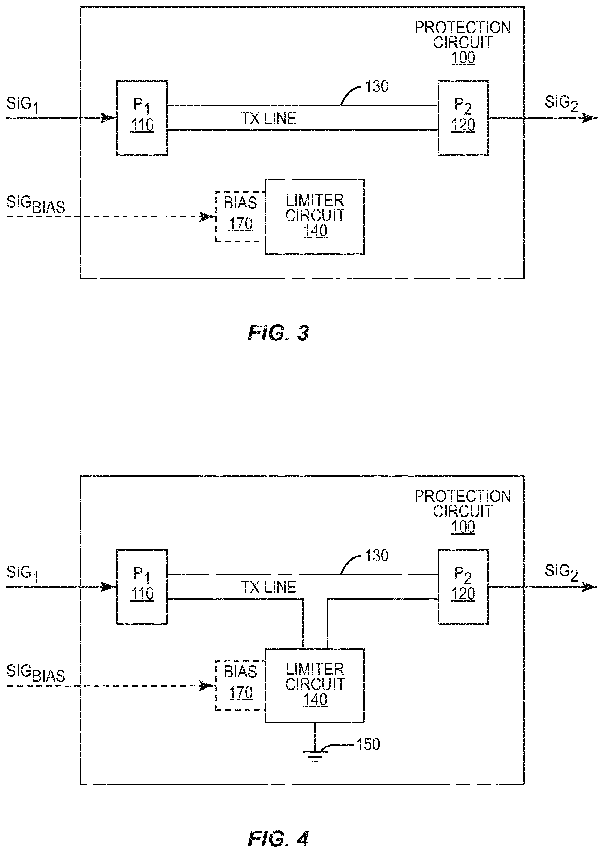

Figure 2 shows a method 200 of protecting the electronic circuits 12 using the protection circuit 100 according to examples disclosed herein, where the protection circuit 100 comprises a first port P₁ 110 and a second port P₂ 120 on opposing ends of a transmission line 130 as shown in Figures 3 and 4, and where the second port 120 electrically connects to one or more of the electronic circuits 12. The protection circuit 100 also includes a limiter circuit 140 operatively connected to the transmission line 130, where the limiter circuit 140 includes a phase changing material in communication with a resonator. First port 110 receives a signal *SIG₁* (block 210). When the energy of the received signal *SIG₁* exceeds a threshold *T* (block 220), the protection circuit 100 limits an energy of the signal *SIG₂* at the second port 120 using the phase changing material configured in a limiting state (block 230). When the energy of the received signal *SIG₁* is less than the threshold *T* (block 220), however, the protection circuit 100 passes *SIG₁* to the second port 120 using the phase changing material configured in a non-limiting state (block 240).

According to one example, the threshold *T* comprises a fixed threshold that is predetermined during manufacture, e.g., based on the sensitivities of the electronic circuits 12 connected to the protection circuit 100. Alternatively, the threshold may comprise a variable threshold, e.g., controlled by a bias signal *SIG_{BIAS}.* For this example, the protection circuit 100 may further comprise a bias connector 170, as shown in Figures 3 and 4, where a bias signal *SIG_{BIAS}* applied to the bias connector 170 controls the threshold T. As such, protection circuit 100 may adjust the sensitivity of the limiter circuit 140 to the input signal as needed, e.g., in response to an increasing/decreasing sensitivity of one or more electronic circuits 12 to high power signals. Regardless of whether the threshold is fixed or variable, it will be appreciated that the threshold is set, or selected to be, at a level that prevents the corresponding electronic circuits 12 from being damaged. For example, the threshold may be set to protect a low-noise amplifier from signals greater than 1 Watt.

Figure 3 shows an example of a protection circuit 100, not encompassed by the wording of the claims, where the limiter circuit 140 controls an impedance of the transmission line 130. More particularly, the limiter circuit 140 for this example selectively electromagnetically (e.g., capacitively or inductively) couples to the transmission line 130 responsive to the energy of the signal *SIG₁* received at the first port 110, and thus selectively controls the impedance of the second port 120 relative to the impedance of the first port 110. To that end, when the phase changing material in the limiter circuit 140 is in a non-limiting state, the limiter circuit 140 is tuned to match the impedance of the transmission line 130, and thus does not electromagnetically couple to the transmission line 130. As such, the impedance of the second port 120 substantially matches the impedance of the first port 110, enabling the signal applied to the first port 110 to pass to the second port 120 with little to no insertion loss. When the energy of the signal *SIG₁* applied to the first port 110 exceeds a threshold, however, the phase changing material transitions to a limiting state, causing the limiter circuit 140 to highly mismatch the impedance of the transmission line 130 via electromagnetic coupling. This electromagnetic coupling changes the impedance of the second port 120 relative to the first port 110. The resulting impedance mismatch attenuates the energy of the input signal *SIG₁* by reflecting most, if not all, of the energy of *SIG₁* back towards the first port 110, and thus limits the power of the signal *SIG₂* output by the second port 120.

Figure 4 shows another example of a protection circuit 100, where the limiter circuit 140 redirects high power input signals away from the second port 120. More particularly, the limiter circuit 140 selectively connects the transmission line 130 to ground 150 responsive to the energy of the signal received at the first port 110, and thus selectively redirects the signal applied to the first port 110 to ground 150. To that end, when the phase changing material in the limiter circuit 140 is in a non-limiting state, the limiter circuit 140 is an open circuit that prevents the transmission line 130 from connecting to ground 150, enabling the signal applied to the first port 110 to pass to the second port 120 with little to no insertion loss. When the energy of the signal *SIG₁* applied to the first port 110 exceeds a threshold, however, the phase changing material transitions to a limiting state, causing the limiter circuit 140 to electrically connect the transmission line 130 to ground 150. As such, when the phase changing material is in the limiting state, the limiter circuit 140 redirects the signal applied to the first port 110 to ground, preventing most, if not all, of *SIG₁* from reaching the second port 120.

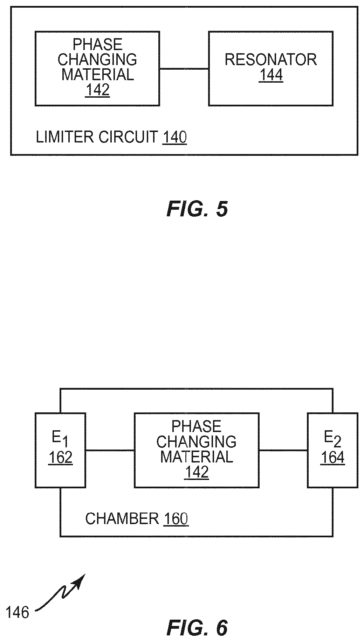

Figure 5 shows one example of a limiter circuit 140. As shown in Figure 5, the limiter circuit 140 comprises phase changing material 142 incorporated inside selective parts or adjacent to the resonator 144. The phase changing material 142 may comprise any material that changes phase responsive to the energy of an applied input signal, including but not limited to air, a noble gas, a thermochromic material, an electrochromic material (e.g., vanadium dioxide VO₂), etc. It will be appreciated that in some examples, the phase changing material 142 may absorb some of the energy of the signal applied to the first port 110 when the phase changing material 142 is in the limiting state. This property of the limiter circuit 140 depends on the material used for the phase changing material 142 and/or the actual orientation of the limiter circuit 140 relative to the transmission line 130. The phase changing material 142 in the conductive state, may it be a gas turned into plasma or an insulator material turned into a conductor, still has appreciable resistivity, and therefore absorbs some of the signal due to Joule heating. For example, when the phase changing material 142 creates a shunt from the transmission line 130 to ground 150, the high energy signal passes through the limiter circuit 140, resulting in at least some of the energy of *SIG₁* being absorbed by the phase changing material 142.

In some examples, the protection circuit 100 is implemented using a gap chip 146, where the phase changing material 142 is disposed in a sealed chamber160 of the gap chip146. Figure 6 shows an example of one such gap chip 146. In this example, the gap chip 146 comprises a chamber 160, the phase changing material 142, a first electrode 162 and a second electrode 164. The phase changing material 142 is disposed within the sealed chamber 160, while the electrodes 162, 164, are partially disposed within the sealed chamber 160 and extend from opposing sides of the sealed chamber 160, as shown in Figure 6. As a result, when the phase changing material 142 is in a limiting state, e.g., responsive to a high power input signal *SIG₁,* the phase changing material 142 electrically connects the first electrode 162 to the second electrode 164, creating the desired limiting condition, e.g., a shunt to ground when the first electrode 162 connects to the transmission line 130 and the second electrode 164 connects to ground 150.

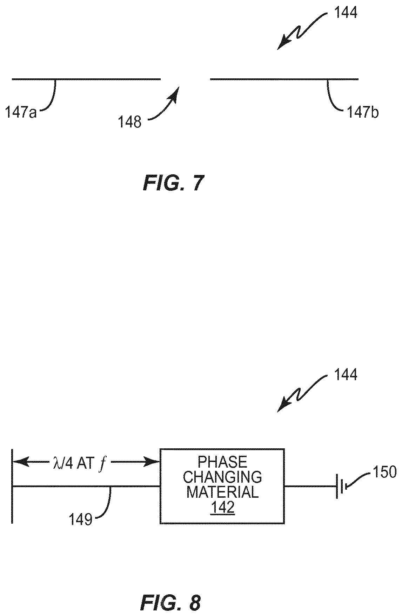

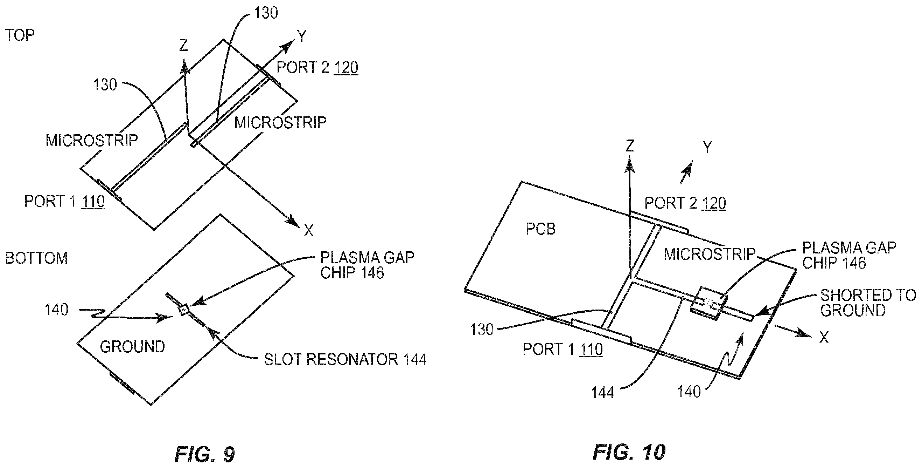

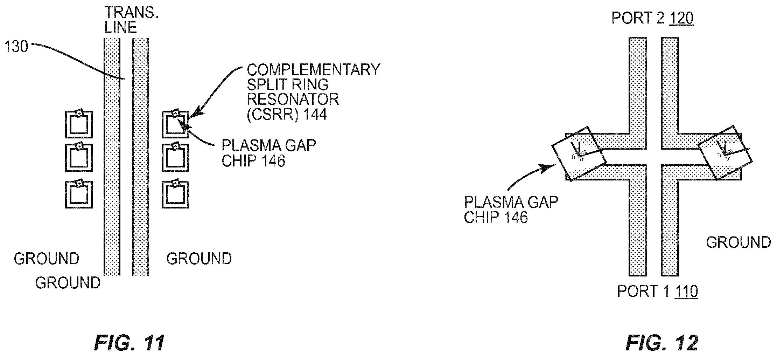

In some examples not encompassed by the wording of the claims, the resonator 144 may comprise any known resonator, e.g., a slot resonator (Figures 7 and 9), complementary split ring resonator (Figure 11), etc. For example, resonator 144 may comprise a slot resonator having a slot or gap 148 disposed between two conductors 147a, 147b, as shown in Figure 7. For this example, the phase changing material 142 is disposed in the gap 148 such that the phase changing material 142 only connects one conductor 147a to the other conductor 147b when the phase changing material 142 is in the limiting state. Alternatively, a gap chip 146 may be disposed between the two conductors 147a, 147b such that one conductor 147a only connects to the other conductor 147b when the phase changing material 142 in the sealed chamber 160 is in the limiting state.

Resonator 144 comprises a quarter wave resonator, as shown in Figure 8. For example, a conductive element 149 having a length of one quarter of a wavelength (at a specified frequency) is connected to ground 150 by the phase changing material 142 when the phase changing material 142 is in the limiting state. Alternatively, gap chip 146 may be disposed between the conductive element 149 and ground 150 such that conductive element 149 only connects to ground 150 (and thus resonates) when the phase changing material 142 in the sealed chamber 160 is in the limiting state.

The protection circuit 100 may be added to any existing printed circuit board (PCB) implementations. For example, the protection circuit may be attached to a PCB using flip chip or wirebond technologies.

Figures 9-12 show exemplary PCB implementations. Figure 9 shows a PCB implementation of a protection circuit 100, not encompassed by the wording of the claims, implemented as a slot resonator (e.g., of Figure 7) and used for selective electromagnetic coupling to the transmission line responsive to the power of the input signal. Figure 10 shows a PCB implementation of a protection circuit 100 that redirects high power input signals to ground. While the examples disclosed herein are generally described in terms of protection circuit 100 comprising a single limiter circuit 140, it will be appreciated that multiple limiter circuits 140 may be used, e.g., as shown in Figures 11 and 12, where figure 11 is not encompassed by the wording of the claims. Such multiple limiter circuit solutions may be used, for example, to provide more than one redirection path, to increase the amount of power able to be handled by the protection circuit 100, to further decrease the signal level reaching the second port 120, etc.

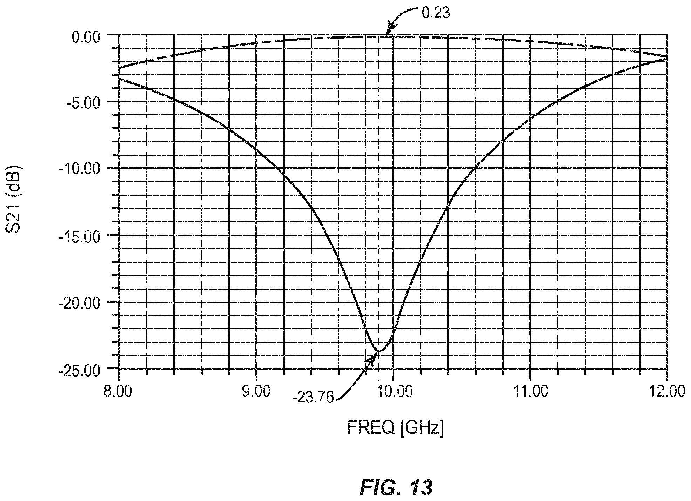

Figure 13 shows performance data for a protection circuit 100 when implemented according to one example (e.g., the example of Figure 9), where the resonator is configured for operation near 10 GHz. As shown in Figure 13, the transmitted signal at the second port 120 is at -0.23 dB, or nearly 100% transmitted in the non-limiting state. In the limiting state, the transmitted signal at the second port 120 is at -23.76 dB, or attenuated more than 200 times. Better performance designs can be achieved depending on the specific requirements and device complexity.

The examples disclosed herein have several advantages over conventional surge protection solutions, i.e., PIN diodes. For example, the protection circuits 100 disclosed herein are cheaper to implement (e.g., up to 90% cheaper), can handle higher input powers than the PIN diode (e.g., signals with up to 100 times more power or total energy), and have minimal insertion loss when in the non-limiting state (e.g., as compared to insertion losses of about 1 dB for PIN diodes).
The examples disclosed herein may, of course, be carried out in other ways than those specifically set forth herein without departing from essential characteristics of the described protection circuit which are set forth in the appended independent claims. The present examples are to be considered in all respects as illustrative and not restrictive.

## Claims

1. A protection circuit (100) configured to protect one or more electronic circuits (12) from high power signals, the protection circuit (100) comprising:
a first port (110) and a second port (120) respectively electrically connected to opposing ends of a transmission line (130), the second port (120) operatively coupled to the one or more electronic circuits (12); and
a limiter circuit (140) selectively electrically coupled between the transmission line (130) and ground (150);
wherein the limiter circuit (140) comprises a resonator and a phase changing material (142) in communication with the resonator (144), the phase changing material (142) configured in a limiting state when an energy of a signal received at the first port (110) exceeds a threshold to limit an energy of the signal at the second port (120);
wherein the resonator (144) comprises a quarter wave resonator (149) selectively electrically connected to the ground (150) via the phase changing material (142); and
wherein the limiting state comprises a conductive state that electrically connects the quarter wave resonator (149) to the ground (150) to redirect at least a portion of the energy of the signal received at the first port (110) to the ground (150).

2. The protection circuit (100) of claim 1 wherein the phase changing material (142) is configured in a non-limiting state when the energy of the signal received at the first port (110) is less than the threshold.

3. The protection circuit (100) of any preceding claim wherein the quarter wave resonator (149) comprises a conductive element having a length of one quarter of a wavelength at a predetermined frequency.

4. The protection circuit (100) of any preceding claim wherein the phase changing material (142) configured in the limiting state absorbs at least some of the energy of the signal received at the first port (110) to limit the energy of the signal at the second port (120).

5. The protection circuit (100) of any preceding claim further comprising a gap chip (146) comprising:
a sealed chamber (160), wherein the phase changing material (142) is disposed in the sealed chamber (160);
a first conductor (162) at least partially disposed within the sealed chamber (160) and extending from the sealed chamber (160); and
a second conductor (164) spaced from the first conductor (162), the second conductor (164) at least partially disposed within the sealed chamber (160) and extending from the sealed chamber (160);
wherein the first and second conductors (162, 164) electrically connect to the resonator (144).

6. The protection circuit (100) of claim 5 wherein the phase changing material (142) comprises air.

7. The protection circuit (100) of claim 5 or claim 6 wherein the phase changing material (142) comprises a noble gas, a thermochromic material, or an electrochromic material.

8. The protection circuit (100) of any of claims 1 to 7 wherein the threshold comprises a fixed threshold.

9. The protection circuit (100) of any of claims 1 to 7 wherein the limiter circuit (140) further comprises a bias connector (170) electrically connected to the resonator (144), and wherein the threshold comprises a variable threshold controlled by a bias signal applied to the bias connector (170).

10. A method (200) of protecting one or more electronic circuits (12) from high power signals, the method comprising:
receiving (210) a signal at a first port (110) of a transmission line (130), wherein the transmission line (130) comprises the first port (110) and a second port (120) respectively electrically connected to opposing ends of the transmission line (130), wherein the second port (120) is operatively coupled to the one or more electronic circuits (12), wherein a limiter circuit (140) is selectively electrically coupled between the transmission line (130) and ground (150), and wherein the limiter circuit (140) comprises a resonator and a phase changing material (142) in communication with the resonator (144);
and
limiting (230) an energy of the signal at the second port (120) when an energy of the signal received at the first port (110) exceeds a threshold (220) using the phase changing material (142) configured in a limiting state;
wherein the resonator (144) comprises a quarter wave resonator (149) selectively electrically connected to the ground (150) via the phase changing material (142); and
wherein the limiting state comprises a conductive state that electrically connects the quarter wave resonator (149) to the ground (150) to redirect at least a portion of the energy of the signal received at the first port (110) to the ground (150).

11. The method (200) of claim 10 further comprising passing (240) the energy of the signal at the first port (110) to the second port (120) when the energy of the signal received at the first port is less than the threshold (220) using the phase changing material (142) configured in a non-limiting state.

12. The method (200) of any of claims 10 to 11 wherein the quarter wave resonator (149) comprises a conductive element having a length of one quarter of a wavelength at a predetermined frequency.

13. The method (200) of any of claims 10 to 12 wherein the threshold comprises a fixed threshold.

14. The method (200) of any of claims 10 to 12 wherein the threshold comprises a variable threshold, the method further comprising controlling the threshold by controlling a bias signal applied to the resonator (144).

15. An aircraft (10) comprising:
one or more electronic circuits (12) configured to control an operation of the aircraft (10); and
a protection circuit (100) according to any of claims 1 to 9.

## Patentansprüche

1. Schutzschaltung (100), die konfiguriert ist, eine oder mehrere elektronische Schaltungen (12) vor Hochleistungssignalen zu schützen, wobei die Schutzschaltung (100) umfasst:
einen ersten Anschluss (110) und einen zweiten Anschluss (120), die jeweils elektrisch mit gegenüberliegenden Enden einer Übertragungsleitung (130) verbunden sind, wobei der zweite Anschluss (120) betriebsfähig mit dem einem oder mehreren elektronischen Schaltungen (12) gekoppelt ist; und
eine Begrenzerschaltung (140), die selektiv elektrisch zwischen der Übertragungsleitung (130) und Masse (150) gekoppelt ist;
wobei die Begrenzerschaltung (140) einen Resonator und ein Phasenwechselmaterial (142) umfasst, das mit dem Resonator (144) in Verbindung steht, wobei das Phasenwechselmaterial (142) in einem begrenzenden Zustand konfiguriert ist, wenn eine Energie eines am ersten Anschluss (110) empfangenen Signals eine Schwelle überschreitet, um eine Energie des Signals am zweiten Anschluss (120) zu begrenzen;
wobei der Resonator (144) einen Viertelwellenresonator (149) umfasst, der selektiv über das Phasenwechselmaterial (142) elektrisch mit der Masse (150) verbunden ist; und
wobei der begrenzende Zustand einen leitfähigen Zustand umfasst, der den Viertelwellenresonator (149) elektrisch mit der Masse (150) verbindet, um mindestens einen Abschnitt der Energie des am ersten Anschluss (110) empfangenen Signals gegen die Masse (150) umzuleiten.

2. Schutzschaltung (100) nach Anspruch 1, wobei das Phasenwechselmaterial (142) in einem nicht begrenzenden Zustand konfiguriert ist, wenn die Energie des am ersten Anschluss (110) empfangenen Signals geringer als die Schwelle ist.

3. Schutzschaltung (100) nach einem vorstehenden Anspruch, wobei der Viertelwellenresonator (149) ein leitfähiges Element umfasst, das eine Länge von einem Viertel einer Wellenlänge bei einer vorbestimmten Frequenz aufweist.

4. Schutzschaltung (100) nach einem vorstehenden Anspruch, wobei das im begrenzenden Zustand konfigurierte Phasenwechselmaterial (142) mindestens etwas von der Energie des am ersten Anschluss (110) empfangenen Signals absorbiert, um die Energie des Signals am zweiten Anschluss (120) zu begrenzen.

5. Schutzschaltung (100) nach einem vorstehenden Anspruch, weiter umfassend einen Gap-Chip (146), umfassend:
eine abgedichtete Kammer (160), wobei das Phasenwechselmaterial (142) in der abgedichteten Kammer (160) angeordnet ist;
einen ersten Leiter (162), der mindestens teilweise innerhalb der abgedichteten Kammer (160) angeordnet ist und sich von der abgedichteten Kammer (160) erstreckt; und
einen zweiten Leiter (164), der von dem ersten Leiter (162) beabstandet ist, wobei der zweite Leiter (164) mindestens teilweise innerhalb der abgedichteten Kammer (160) angeordnet ist und sich von der abgedichteten Kammer (160) erstreckt;
wobei der erste und zweite Leiter (162, 164) elektrisch mit dem Resonator (144) verbunden sind.

6. Schutzschaltung (100) nach Anspruch 5, wobei das Phasenwechselmaterial (142) Luft umfasst.

7. Schutzschaltung (100) nach Anspruch 5 oder Anspruch 6, wobei das Phasenwechselmaterial (142) ein Edelgas, ein thermochromes Material oder ein elektrochromes Material umfasst.

8. Schutzschaltung (100) nach einem der Ansprüche 1 bis 7, wobei die Schwelle eine feste Schwelle umfasst.

9. Schutzschaltung (100) nach einem der Ansprüche 1 bis 7, wobei die Begrenzerschaltung (140) weiter einen mit dem Resonator (144) elektrisch verbundenen Vorspannungsverbinder (170) umfasst und wobei die Schwelle eine variable Schwelle umfasst, die durch ein an den Vorspannungsverbinder (170) angelegtes Vorspannungssignal gesteuert wird.

10. Verfahren (200) zum Schützen einer oder mehrerer elektronischer Schaltungen (12) vor Hochleistungssignalen, wobei das Verfahren umfasst:
Empfangen (210) eines Signals an einem ersten Anschluss (110) einer Übertragungsleitung (130), wobei die Übertragungsleitung (130) den ersten Anschluss (110) und einen zweiten Anschluss (120) umfasst, die jeweils elektrisch mit gegenüberliegenden Enden der Übertragungsleitung (130) verbunden sind, wobei der zweite Anschluss (120) betriebsfähig mit einer oder mehreren elektronischen Schaltungen (12) gekoppelt ist, wobei eine Begrenzerschaltung (140) selektiv elektrisch zwischen der Übertragungsleitung (130) und Masse (150) gekoppelt ist und wobei die Begrenzerschaltung (140) einen Resonator und ein Phasenwechselmaterial (142) umfasst, das mit dem Resonator (144) in Verbindung steht; und
Begrenzen (230) einer Energie des Signals am zweiten Anschluss (120), wenn eine Energie des am ersten Anschluss (110) empfangenen Signals eine Schwelle (220) überschreitet, unter Verwendung des in einem begrenzten Zustand konfigurierten Phasenwechselmaterials (142);
wobei der Resonator (144) einen Viertelwellenresonator (149) umfasst, der selektiv über das Phasenwechselmaterial (142) elektrisch mit der Masse (150) verbunden ist; und
wobei der begrenzende Zustand einen leitfähigen Zustand umfasst, der den Viertelwellenresonator (149) elektrisch mit der Masse (150) verbindet, um mindestens einen Abschnitt der Energie des am ersten Anschluss (110) empfangenen Signals gegen die Masse (150) umzuleiten.

11. Verfahren (200) nach Anspruch 10, weiter umfassend Weiterleiten (240) der Energie des Signals am ersten Anschluss (110) zum zweiten Anschluss (120), wenn die Energie des am ersten Anschluss empfangenen Signals geringer als die Schwelle (220) ist, unter Verwendung des in einem nicht begrenzenden Zustand konfigurierten Phasenwechselmaterials (142).

12. Verfahren (200) nach einem der Ansprüche 10 bis 11, wobei der Viertelwellenresonator (149) ein leitfähiges Element umfasst, das eine Länge von einem Viertel einer Wellenlänge bei einer vorbestimmten Frequenz aufweist.

13. Verfahren (200) nach einem der Ansprüche 10 bis 12, wobei die Schwelle eine feste Schwelle umfasst.

14. Verfahren (200) nach einem der Ansprüche 10 bis 12, wobei die Schwelle eine variable Schwelle umfasst, wobei das Verfahren weiter Steuern der Schwelle durch Steuern eines an den Resonator (144) angelegten Vorspannungssignals umfasst.

15. Luftfahrzeug (10), umfassend:
eine oder mehrere elektronische Schaltungen (12), die konfiguriert sind, einen Betrieb des Luftfahrzeugs (10) zu steuern; und
eine Schutzschaltung (100) nach einem der Ansprüche 1 bis 9.

## Revendications

1. Circuit de protection (100) configuré pour protéger un ou plusieurs circuits électroniques (12) de signaux de forte puissance, le circuit de protection (100) comprenant :
un premier port (110) et un second port (120) respectivement connectés électriquement aux extrémités opposées d'une ligne de transmission (130), le second port (120) étant couplé fonctionnellement aux un ou plusieurs circuits électroniques (12) ; et
un circuit limiteur (140) couplé électriquement de manière sélective entre la ligne de transmission (130) et la masse (150) ;
dans lequel le circuit limiteur (140) comprend un résonateur et un matériau à changement de phase (142) en communication avec le résonateur (144), le matériau à changement de phase (142) étant configuré dans un état de limitation lorsqu'une énergie d'un signal reçu au niveau du premier port (110) dépasse un seuil pour limiter une énergie du signal au niveau du second port (120) ;
dans lequel le résonateur (144) comprend un résonateur quart d'onde (149) connecté électriquement de manière sélective à la masse (150) via le matériau à changement de phase (142) ; et
dans lequel l'état de limitation comprend un état conducteur qui connecte électriquement le résonateur quart d'onde (149) à la masse (150) pour rediriger au moins une partie de l'énergie du signal reçu au niveau du premier port (110) vers la masse (150).

2. Circuit de protection (100) selon la revendication 1 dans lequel le matériau à changement de phase (142) est configuré dans un état de non-limitation lorsque l'énergie du signal reçu au niveau du premier port (110) est inférieure au seuil.

3. Circuit de protection (100) selon une quelconque revendication précédente dans lequel le résonateur quart d'onde (149) comprend un élément conducteur présentant une longueur d'un quart d'une longueur d'onde à une fréquence prédéterminée.

4. Circuit de protection (100) selon une quelconque revendication précédente dans lequel le matériau à changement de phase (142) configuré dans l'état de limitation absorbe au moins une partie de l'énergie du signal reçu au niveau du premier port (110) pour limiter l'énergie du signal au niveau du second port (120).

5. Circuit de protection (100) selon une quelconque revendication précédente comprenant en outre une puce d'écartement (146) comprenant :
une chambre scellée (160), dans lequel le matériau à changement de phase (142) est disposé dans la chambre scellée (160) ;
un premier conducteur (162) au moins partiellement disposé à l'intérieur de la chambre scellée (160) et s'étendant à partir de la chambre scellée (160) ; et
un second conducteur (164) espacé du premier conducteur (162), le second conducteur (164) étant au moins partiellement disposé à l'intérieur de la chambre scellée (160) et s'étendant à partir de la chambre scellée (160) ;
dans lequel les premier et second conducteurs (162, 164) sont connectés électriquement au résonateur (144).

6. Circuit de protection (100) selon la revendication 5 dans lequel le matériau à changement de phase (142) comprend de l'air.

7. Circuit de protection (100) selon la revendication 5 ou la revendication 6 dans lequel le matériau à changement de phase (142) comprend un gaz noble, un matériau thermochromique ou un matériau électrochromique.

8. Circuit de protection (100) selon l'une quelconque des revendications 1 à 7 dans lequel le seuil comprend un seuil fixe.

9. Circuit de protection (100) selon l'une quelconque des revendications 1 à 7 dans lequel le circuit limiteur (140) comprend en outre un connecteur de polarisation (170) connecté électriquement au résonateur (144), et dans lequel le seuil comprend un seuil variable commandé par un signal de polarisation appliqué au connecteur de polarisation (170).

10. Procédé (200) de protection d'un ou plusieurs circuits électroniques (12) de signaux de forte puissance, le procédé comprenant :
la réception (210) d'un signal au niveau d'un premier port (110) d'une ligne de transmission (130), dans lequel la ligne de transmission (130) comprend le premier port (110) et un second port (120) respectivement connectés électriquement aux extrémités opposées de la ligne de transmission (130), dans lequel le second port (120) est couplé fonctionnellement aux un ou plusieurs circuits électroniques (12), dans lequel un circuit limiteur (140) est couplé électriquement de manière sélective entre la ligne de transmission (130) et la masse (150), et dans lequel le circuit limiteur (140) comprend un résonateur et un matériau à changement de phase (142) en communication avec le résonateur (144) ; et
la limitation (230) d'une énergie du signal au niveau du second port (120) lorsqu'une énergie du signal reçu au niveau du premier port (110) dépasse un seuil (220) en utilisant le matériau à changement de phase (142) configuré dans un état de limitation ;
dans lequel le résonateur (144) comprend un résonateur quart d'onde (149) connecté électriquement de manière sélective à la masse (150) via le matériau à changement de phase (142) ; et
dans lequel l'état de limitation comprend un état conducteur qui connecte électriquement le résonateur quart d'onde (149) à la masse (150) pour rediriger au moins une partie de l'énergie du signal reçu au niveau du premier port (110) vers la masse (150).

11. Procédé (200) selon la revendication 10 comprenant en outre le passage (240) de l'énergie du signal au niveau du premier port (110) au second port (120) lorsque l'énergie du signal reçu au niveau du premier port est inférieure au seuil (220) en utilisant le matériau à changement de phase (142) configuré dans un état de non-limitation.

12. Procédé (200) selon l'une quelconque des revendications 10 et 11 dans lequel le résonateur quart d'onde (149) comprend un élément conducteur présentant une longueur d'un quart d'une longueur d'onde à une fréquence prédéterminée.

13. Procédé (200) selon l'une quelconque des revendications 10 à 12 dans lequel le seuil comprend un seuil fixe.

14. Procédé (200) selon l'une quelconque des revendications 10 à 12, dans lequel le seuil comprend un seuil variable, le procédé comprenant en outre la commande du seuil en commandant un signal de polarisation appliqué au résonateur (144).

15. Aéronef (10) comprenant :
un ou plusieurs circuits électroniques (12) configurés pour commander une opération de l'aéronef (10) ; et
un circuit de protection (100) selon l'une quelconque des revendications 1 à 9.
